(19) Europäisches Patentamt
European Patent Office
Office européen des brevets

(11) **EP 3 259 811 B1**

(12) **EUROPÄISCHE PATENTSCHRIFT**

(45) Veröffentlichungstag und Bekanntmachung des Hinweises auf die Patenterteilung:
**17.09.2025   Patentblatt 2025/38**

(21) Anmeldenummer: **16704864.4**

(22) Anmeldetag: **18.02.2016**

(51) Internationale Patentklassifikation (IPC):
*H01S 5/10* (2021.01)          *H01S 5/042* (2006.01)
*H01S 5/12* (2021.01)          *H01S 5/22* (2006.01)
*H01S 5/50* (2006.01)          *H01S 5/20* (2006.01)
*H01S 5/022* (2021.01)

(52) Gemeinsame Patentklassifikation (CPC):
**H01S 5/1064; H01S 5/0421; H01S 5/2036; H01S 5/22;** H01S 5/1203; H01S 5/50

(86) Internationale Anmeldenummer:
**PCT/EP2016/053442**

(87) Internationale Veröffentlichungsnummer:
**WO 2016/131910 (25.08.2016 Gazette 2016/34)**

(54) **LASERDIODE MIT VERBESSERTEN ELEKTRISCHEN LEITEIGENSCHAFTEN**

LASER DIODE WITH IMPROVED ELECTRICAL CONDUCTION PROPERTIES

DIODE LASER PRÉSENTANT DES PROPRIÉTÉS ÉLECTROCONDUCTRICES AMÉLIORÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2015   DE 102015203113**

(43) Veröffentlichungstag der Anmeldung:
**27.12.2017   Patentblatt 2017/52**

(60) Teilanmeldung:
**23203171.6 / 4 283 802**

(73) Patentinhaber: **Ferdinand-Braun-Institut gGmbH, Leibniz-Institut für Höchstfrequenztechnik 12489 Berlin (DE)**

(72) Erfinder:
• **FRICKE, Jörg**
  **10319 Berlin (DE)**
• **DECKER, Jonathan**
  **12437 Berlin (DE)**
• **CRUMP, Paul**
  **10245 Berlin (DE)**
• **ERBERT, Götz**
  **02708 Löbau (DE)**

(74) Vertreter: **Gulde & Partner Patent- und Rechtsanwaltskanzlei mbB Berliner Freiheit 2 10785 Berlin (DE)**

(56) Entgegenhaltungen:
DE-A1- 102008 014 092     US-A- 5 392 308
US-A- 5 793 521                US-A- 6 014 396
US-A- 6 148 013

## Beschreibung

Die Erfindung betrifft eine Laserdiode mit verbesserten elektrischen Leiteigenschaften sowie einen entsprechenden Diodenlaser.

## Einleitung

Für Höchstleistungsanwendungen werden Diodenlaser auf einem wärmeleitfähigen Träger gelötet. Hierbei werden die epitaktischen Schichten, normalerweise die p-dotierte Seite, für eine optimale Kühlung direkt auf den Träger gelötet. Bei dieser Konfiguration ist die ganze p-Seite elektrisch kontaktiert und wird somit mit einer gemeinsamen Spannung betrieben. In vielen Bereichen, zum Beispiel in der Materialbearbeitung, werden größere Systeme mit höheren Leistungen benötigt. Hierzu werden die Diodenlaser in größeren flächigen Bereichen (Arrays) zu sogenannten Laserbarren angeordnet. Alle Laserbarren werden dabei gemeinsam angesteuert.

## Stand der Technik

Um verbesserte elektrooptische Eigenschaften wie beispielsweise eine verbesserten Strahlqualität realisieren zu können, werden häufig einzelne Sektionen der Laserdiode getrennt angesteuert. Ein bekanntes derartiges Bauelement ist beispielsweise eine Trapezlaserdiode.

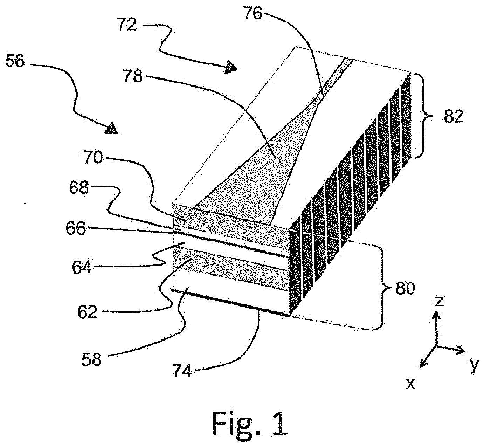

Figur 1 zeigt eine schematische Darstellung einer konventionellen Trapezlaserdiode 56. Auf einem Substrat 58 sind eine n-Mantelschicht 62, eine n-Wellenleiterschicht 64, eine Schicht mit einer aktiven Zone 66 sowie eine p-Wellenleiterschicht 68 und eine p-Mantelschicht 70 aufgebracht. Des Weiteren weist die Trapezlaserdiode 56 einen p-Kontaktbereich 72 und einen n-Kontaktbereich 74 auf, wobei der p-Kontaktbereich 72 aus einem Rippenwellenleiterbereich 76 und einem Trapezbereich 78 besteht. Die Trapezlaserdiode 56 wird durch eine Frontfacette 80 und eine Rückfacette 82 begrenzt.

Wie beispielsweise aus C. Fiebig et al., IEEE JSTQE 15(3), pp. 978-983 (2009); K. Paschke et al., IEEE JSTQE 11(5), pp. 1223-1226 (2005) und B. Sumpf et al., Opt. Quant. Electron. 35, pp. 521-532 (2003) bekannt, hängen die Strahlqualität und die erreichbare Maximalleistung, beziehungsweise der Konversionswirkungsgrad, von dem Verhältnis der eingebrachten Ströme in den Rippenwellenleiterbereich 76 und den Trapezbereich 78 sowie von den Geometrien dieser Bereiche ab.

An einzeln aufgebauten Trapezlasern wird das Verhältnis der jeweils in den Rippenwellenleiterbereich 76 und in den Trapezbereich 78 eingebrachten Ströme über eine separate Ansteuerung des Rippenwellenleiterbereichs und des Trapezbereichs eingestellt. Dies führt jedoch zu Nachteilen bei den Herstellkosten sowie in Bezug auf die Kühlung und Leistungsskalierung bei größeren Systemen. Werden Rippenwellenleiter 76 und Trapezbereich 78 zur Ermöglichung einer gemeinsamen Ansteuerung kurzgeschlossen, führt dies jedoch zu verschlechterten Eigenschaften, wie reduzierter Leistung, geringerem Wirkungsgrad und einer verschlechterten Strahlqualität. Bekannte Maßnahmen, um dem entgegen zu wirken, bestehen unter anderem in einer Verringerung des Trapezbereichs bei gleichzeitiger Verlängerung des Rippenwellenleiterbereichs. Jedoch konnten diese Maßnahmen die Nachteile bislang nicht kompensieren.

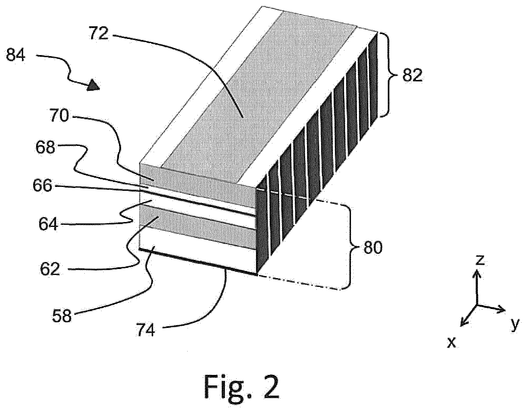

Eine konventionelle Breitstreifenlaserdiode 84 ist in Figur 2 gezeigt. Auf Grund des ähnlichen Aufbaus wird auf dieselben Bezugszeichen, wie bei der Trapezlaserdiode 56 aus Figur 1 zurückgegriffen. Auch die Breitstreifenlaserdiode 84 weist eine Frontfacette 80 und eine Rückfacette 82 auf. Auf einem Substrat 58 sind eine n-Mantelschicht 62, eine n-Wellenleiterschicht 64, eine Schicht mit einer aktiven Zone 66, eine p-Wellenleiterschicht 68 und einer p-Mantelschicht 70 aufgebracht. Des Weiteren weist die Breitstreifenlaserdiode 84 einen p-Kontaktbereich 72 und einen n-Kontaktbereich 74 auf.

Wie beispielsweise aus H. Wenzel et al., New J. Phys. 12, p. 085007 (2010) bekannt, erweist sich das Auftreten von Lochbrennungseffekten als nachteilig im Zusammenhang mit Breitstreifenlaserdioden. Darunter versteht man die Entstehung von räumlichen Zonen der Laserdiode, die weniger zum Laserprozess beitragen, zum Beispiel eine lokale Reduzierung des Gewinns wegen räumlichen Lochbrennens oder eine reduzierte Verstärkung erwünschter Frequenzen (spektrales Lochbrennen).

Das Problem des longitudinalen Lochbrennens wird beispielsweise in J. Feng et al., Appl. Phys. Lett. 66, pp. 2028-2030 (1995) durch getrennte Kontaktierung gelöst, die jedoch komplex und damit teuer ist. Ein weiterer nachteiliger Aspekt ist die Bildung thermischer Linsen. Dabei beeinflusst eine inhomogene Temperaturverteilung im optischen Medium, zum Beispiel bedingt durch den elektrischen Stromfluss und die resultierende lokale Selbsterwärmung, die zusätzliche Wellenführung und eine konsequente ungewünschte Zunahme des Divergenzwinkels erzeugt (P. Crump et al., Semicond. Sci. Technol. 27, 045001 (2012)). Das Problem der thermischen Linse wurde beispielsweise in E. O'Neill et al., IEE Proc. Optoelectron. 147, pp. 31-35 (2000) durch externe Heizelemente (externe Laserstrahlung) gelöst, die jedoch komplex und damit teuer ist.

US 6,148,013 A betrifft ein optoelektronisches III-V Halbleiterbauelement für die Emission von Strahlung hoher Leistung bei sichtbarer Wellenlänge mit einem lateral gleichförmigen, beugungsbegrenzten, quasi-Gauß'schen Strahlprofil. US 6,014,396 A offenbart eine ähnliche aufgeweitete optoelektronische Halbleitervorrichtung.

US 6,014,396 A zeigt differentiell strukturierte gepumpte Halbleiter-Verstärkungsmedien. Der Verstärker wird an seinem Eingangsende mit einer Stromdichte gepumpt, die kleiner ist als die Stromdichte, mit der das Ausgangsende gepumpt wird, um die Kohärenz des Strahls durch differentielles Pumpen auf hohen Leistungsniveaus zu erhalten.

Es wird ebenfalls auf US 5,793,521 und US 5,392,308A verwiesen.

Eine Aufgabe der vorliegenden Erfindung besteht darin, eine Breitstreifenlaserdiode mit verbessertem Aufbau zu schaffen, bei der das Auftreten von Lochbrennungseffekten vermieden wird.

## Offenbarung der Erfindung

Diese Aufgaben werden durch die Merkmale des unabhängigen Patentanspruchs 1 gelöst. Weitere vorteilhafte Ausgestaltungen der vorliegenden Erfindung ergeben sich aus den in den Unteransprüchen genannten Merkmalen.

Gemäß einem ersten, von den Ansprüchen nicht umfassten Aspekt der vorliegenden Offenbarung wird eine Laserdiode offenbart, aufweisend: zumindest eine aktive Schicht, die innerhalb eines Resonators angeordnet und mit einem Auskoppelelement wirkverbunden ist und die zumindest eine Kontaktschicht zum Einkoppeln von Ladungsträgern in die aktive Schicht aufweist, wobei der Resonator mindestens eine erste Sektion und eine zweite Sektion aufweist, wobei sich die maximale Breite der aktiven Schicht in der ersten Sektion von der maximalen Breite der aktiven Schicht in der zweiten Sektion unterscheidet und eine Projektion der Kontaktschicht entlang einer ersten sich senkrecht zur aktiven Schicht erstreckenden Achse sowohl mit der ersten Sektion als auch mit der zweiten Sektion überlappt. Erfindungsgemäß ist dabei vorgesehen, dass die zweite Sektion eine Vielzahl separater Widerstandselemente aufweist, deren spezifischer elektrischer Widerstand größer, als der spezifische elektrische Widerstand der Bereiche zwischen benachbarten Widerstandselementen ist und eine Breite der Widerstandselemente entlang einer Längsachse der aktiven Schicht kleiner als 20 μm ist und eine Projektion der Widerstandselemente auf die aktive Schicht entlang der ersten Achse mit mindestens 10 % der aktiven Schicht überlappt.

Der Vorteil besteht darin, dass der elektrische Gesamtwiderstand in der zweiten Sektion soweit erhöht wird, dass ein größerer Anteil des Stromes durch die erste Sektion fließt. Durch auslegungsfallbezogene Dimensionierung kann ein optimales Verhältnis zwischen dem Stromanteil in der ersten Sektion und dem Stromanteil in der zweiten Sektion eingestellt werden. Trotz einer gemeinsamen Kontaktierung der ersten und zweiten Sektion stellt sich so eine optimale Stromaufteilung ein.

Vorzugsweise weist die erste Sektion keine Widerstandselemente auf.

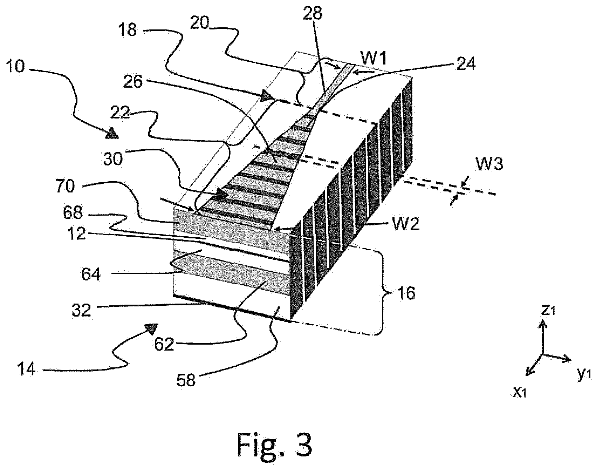

Vorzugsweise ist die zweite Sektion derart ausgebildet, dass die Stromdichte innerhalb der zweiten Sektion (auch als Verstärker-Sektion bezeichnet) über je ein Widerstandselement und je einen Bereich zwischen zwei Widerstandselementen longitudinal uniform ist. Dies bedeutet, dass eine maximale Stromdichte und eine minimale Stromdichte über je ein Widerstandselement und je einen Bereich zwischen zwei Widerstandselementen während des Betriebs bevorzugt um weniger als 20%, bevorzugter um weniger als 10%, noch bevorzugter um weniger als 5%, noch bevorzugter um weniger als 2% und noch bevorzugter um weniger als 1% abweicht. In gleicher Weise ist es bevorzugt, dass die zweite Sektion derart ausgebildet ist, dass der spezifische elektrische Widerstand innerhalb der zweiten Sektion über je ein Widerstandselement und je einen Bereich zwischen zwei Widerstandselementen longitudinal uniform ist. Dies bedeutet bevorzugt, dass ein Maximum des spezifischen elektrischen Widerstands von einem Minimum des spezifischen elektrischen Widerstands in longitudinaler Richtung (d.h. entlang der Längsachse (Achse X1 in Figur 3)) über je ein Widerstandselement und je einen Bereich zwischen zwei Widerstandselementen um weniger als 20%, bevorzugter um weniger als 10%, noch bevorzugter um weniger als 5%, noch bevorzugter um weniger als 2% und noch bevorzugter um weniger als 1% abweicht.

Dadurch kann die Stromdichte vorteilhafterweise nur in der ersten Sektion (auch als single mode Sektion bezeichnet) erhöht werden.

Vorzugsweise beträgt die Länge der zweiten Sektion größer als 50%, bevorzugter größer als 60% der Gesamtlänge (=Summe aus Länge der ersten Sektion und Länge der zweiten Sektion), um ausreichend Verstärkung zu erzielen. Vorzugsweise weist die Vorrichtung lediglich genau eine trapezförmig ausgebildete Verstärker-Sektion auf.

Vorzugsweise ist das Verhältnis (Quotient) der Breite der trapezförmig ausgebildeten zweiten Sektion im Bereich der (Austritts-)Facette (Bereich maximaler Breite) zur Breite der ersten Sektion im Bereich der (entgegengesetzten) Facette (maximale Breite) größer als 10, bevorzugter größer als 25, noch bevorzugter größer als 30, noch bevorzugter größer als 50, noch bevorzugter größer als 75 und noch bevorzugter größer als 100. Hierdurch lässt sich eine besonders hohe Verstärkung erzielen.

Vorzugsweise weist die Vorrichtung halbleitenden Wellenleiterschichten und halbleitende Mantelschichten auf. Vorzugsweise weisen die Wellenleiterschichten Aluminiumgalliumarsenid ($Al_xGa_{(1-x)}As$ mit $0 \leq x \leq 1$) auf. Vorzugsweise weisen die Mantelschichten Aluminiumgalliumarsenid auf.

Vorzugsweise erstrecken sich die Widerstandselemente (longitudinal) nahezu über den gesamten Bereich der zweiten Sektion, d.h. vorzugsweise über mindestens 80%, bevorzugter über mindestens 90% und noch bevorzugter über mindestens 95% der zweiten Sektion.

Der Einstellung der relevanten Designparameter kommt in einer bevorzugten Ausführungsvariante der vorliegenden Offenbarung eine besondere Bedeutung zu. So ist der prozentuale Überlappungsanteil der Projektion der Widerstandselemente auf die aktive Schicht entlang der ersten Achse mit der aktiven Schicht vorzugsweise ausreichend groß, um die Stromaufteilung in vorteilhafter Weise zu beeinflussen. Die Widerstandselemente müssen außerdem schmal genug sein, um optische Verluste oder Ladungsträgerverluste vorteilhaft zu minimieren

So kann vorteilhafterweise vorgesehen sein, dass die Projektion der Widerstandselemente auf die aktive Schicht entlang der ersten sich senkrecht zur aktiven Schicht erstreckenden Achse mindestens 20 %, bevorzugt mindestens 30 %, weiterhin bevorzugt mindestens 40 % und besonders bevorzugt mindestens 50 % der gesamten entlang derselben Achse projizierten Fläche der aktiven Schicht bedeckt, jedoch vorzugsweise nicht mehr als 95 % und insbesondere bevorzugt nicht mehr als 99 %. Es ist weiterhin bevorzugt, dass die maximale Ausdehnung der jeweiligen Widerstandselemente entlang der Längsachse der aktiven Schicht nicht größer als 15 $\mu$m, weiterhin bevorzugt nicht größer als 11 $\mu$m und besonders bevorzugt nicht größer als 6 $\mu$m ist, jedoch bevorzugt nicht kleiner als 1 $\mu$m, da herausgefunden wurde, dass eine derartige Einstellung der Designparameter zu verbesserten Leistungen und Wirkungsgraden führt.

Die Widerstandselemente weisen vorzugsweise einen spezifischen elektrischen Widerstand auf, der signifikant größer ist als der spezifische elektrische Widerstand (im Folgenden bezeichnet als $\sigma_c$, beispielsweise $\sigma_c = 1.0\text{x}10^{-3}\,\Omega\cdot$m) der verwendeten epitaktischen Schichtstruktur. Bevorzugt beträgt der spezifische elektrische Widerstand der Widerstandselemente mehr als $2\sigma_c$, (beispielsweise $2.0\text{x}10^{-3}\,\Omega\cdot$m), weiterhin bevorzugt mehr als $10\sigma_c$ (beispielsweise $1.0\text{x}10^{-2}$ $\Omega\cdot$m, weiterhin bevorzugt mehr als $10^2\,\sigma_c$, (beispielsweise $1.0\text{x}10^{-1}\,\Omega\cdot$m, weiterhin bevorzugt mehr als $10^3\,\sigma_c$ (beispielsweise $1.0\text{x}\,\Omega\cdot$m), weiterhin bevorzugt mehr als $10^4\,\sigma_c$, (beispielsweise $1.0\text{x}10^1\,\Omega\cdot$m), weiterhin bevorzugt mehr als $10^5\,\sigma_c$ (beispielsweise $1.0\text{x}10^2\,\Omega\cdot$m), weiterhin bevorzugt mehr als $10^6\,\sigma_c$ (beispielsweise $1.0\text{x}10^{-3}\,\Omega\cdot$m), weiterhin bevorzugt mehr als $10^7\,\sigma_c$ (beispielsweise $1.0\text{x}10^4\,\Omega\cdot$m), weiterhin bevorzugt mehr als $10^8\,\sigma_c$, (beispielsweise $1.0\text{x}10^5$ $\Omega\cdot$m), und besonders bevorzugt mehr als $10^9\,\sigma_c$ (beispielsweise $1.0\text{x}10^6\,\Omega\cdot$m).

In einer weiteren bevorzugten Ausgestaltung, die ebenfalls von den Ansprüchen nicht umfasst ist, ist die erste Sektion als Rippenwellenleiterbereich und die zweite Sektion als Trapezbereich ausgebildet. Dies bietet den Vorteil, dass die Eigenschaften bekannter Trapezlaser hinsichtlich einer höheren Leistung und verbesserten Strahlqualität genutzt werden können, wobei die hierfür bislang erforderliche dezentrale Ansteuerung solcher Trapezlaser entfällt. Mit anderen Worten verfügt sowohl der Rippenwellenleiterbereich (erste Sektion), als auch der Trapezbereich (zweite Sektion) über eine (bevorzugt zwei) gemeinsame Kontaktschicht(en) zum Ein-, beziehungsweise Auskoppeln von Ladungsträgern. Vorzugsweise ist der Trapezbereich dreieckförmig und achssymmetrisch zu einer Längsachse der aktiven Schicht ausgebildet.

In einer weiteren vorteilhaften Ausgestaltung der vorliegenden Erfindung ist vorgesehen, dass die Widerstandselemente mindestens zwei planparallele Flächen aufweisen, deren Normalvektoren parallel zur Längsachse der aktiven Schicht orientiert sind. Dies bietet den Vorteil, dass laterale lokale Filamentierung reduziert wird. Besonders bevorzugt sind die (bevorzugt streifenförmigen) Widerstandselemente mit einer uniformen Schichtdicke (über ihre Längserstreckung).

In besonders bevorzugter Ausgestaltung wird Filamentierung vorteilhafterweise vermieden, indem die Widerstandselemente je mindestens zwei planparallele Flächen aufweisen, die sich über die gesamte Länge des jeweiligen Widerstandselements erstrecken und deren Normalvektoren parallel zur Längsachse der aktiven Schicht orientiert sind. Mit anderen Worten: Die Widerstandselemente weisen in dieser bevorzugten Ausgestaltung eine konstante Breite an jeder Stelle auf und zudem sind alle Widerstandselemente parallel zueinander orientiert. Dies bietet auch den Vorteil, dass optische Verluste und Ladungsträgerverluste minimiert werden.

In weiterer bevorzugter Ausgestaltung, die ebenfalls von den Ansprüchen nicht umfasst ist, sind die Widerstandselemente äquidistant zu einander angeordnet, das heißt die Widerstandselemente sind periodisch entlang der Längsachse der aktiven Schicht angeordnet. Dies trägt vorteilhaft dazu bei, dass die elektrischen und thermischen Eigenschaften der zweiten Sektion entlang der Längsachse der aktiven Schicht (d. h. longitudinal) über je ein Widerstandselement und je einen Bereich zwischen zwei Widerstandselementen hinweg im Mittel konstant bleiben und Leistung sowie Strahlqualität verbessert werden.

In weiterer bevorzugter Ausgestaltung, die ebenfalls von den Ansprüchen nicht umfasst ist, ist ein Verhältnis der spezifischen Widerstände der Widerstandselemente bezogen auf den spezifischen Widerstand der Bereiche zwischen benachbarten Widerstandselementen größer als 2, weiterhin bevorzugt größer als 10, weiterhin bevorzugt größer als $10^2$, weiterhin bevorzugt größer als $10^3$, weiterhin bevorzugt größer als $10^4$, weiterhin bevorzugt größer als $10^5$, weiterhin bevorzugt größer als $10^6$, weiterhin bevorzugt größer als $10^7$, weiterhin bevorzugt größer als $10^8$, und besonders bevorzugt größer als $10^9$.

Weiterhin ist ein nicht von den Ansprüchen umfasster Laser offenbart, der zumindest eine vorangehend beschriebene enthält. Durch Integration mehrere Laserdioden lässt sich die Gesamtleistung des Systems vorteilhaft, zum Beispiel für die Materialbearbeitung, erhöhen. In bevorzugter Ausgestaltung können mehrere erfindungsgemäße Laserdioden miteinander kombiniert werden, um die Leistung des Gesamtsystems vorteilhaft zu erhöhen. Besonders bevorzugt ist eine Parallelschaltung mehrerer Laserdioden zu sogenannten Arrays. Dies bietet den Vorteil, dass die Kontaktschichten der einzelnen Laserdioden oder der Laserdioden in einem Riegelverbund (sogenannten Laserbarren) auf einer gemeinsamen Platine angeordnet sein können, beziehungsweise gemeinsam angesteuert werden können. Weiterhin besonders bevorzugt ist eine Serienschaltung mehrerer Laserdioden oder Laserbarren zu sogenannten Stacks. Dies bietet zum einen den Vorteil, dass der Bauraum hinsichtlich des horizontalen Flächenbedarfs reduziert wird und zum anderen kann eine gemeinsame Ansteuerung der Laserdioden durch Kontaktierung jeweils einer Kontaktschicht der untersten und der obersten Laserdiode des Riegelverbands erfolgen, für vorteilhafterweise eine maximale Leistungsdichte und minimale Herstellungskosten.

Gemäß einem ersten, von den Ansprüchen umfassten Aspekt der Erfindung wird eine Laserdiode offenbart, aufweisend zumindest eine aktive Schicht, die innerhalb eines Resonators angeordnet und mit einer ersten Facette und einer zweite Facette wirkverbunden ist, wobei die zweite Facette als Auskoppelelement ausgebildet ist, zumindest eine Kontaktschicht zum Einkoppeln von Ladungsträgern in die aktive Schicht sowie eine Vielzahl mittels Implantation eingebrachter separater Widerstandselemente, die zwischen der ersten Facette und der zweiten Facette angeordnet sind, wobei der spezifische elektrische Widerstand der Widerstandselemente größer ist als der spezifische elektrische Widerstand von Bereichen zwischen benachbarten Widerstandselementen. Erfindungsgemäß ist vorgesehen, dass eine maximale Ausdehnung der jeweiligen Widerstandselemente entlang einer Längsachse der aktiven Schicht kleiner als 20 $\mu$m ist und eine Gesamtfläche der Widerstandselemente in einer der ersten Facette zugewandten Hälfte des Resonators größer oder gleich der Gesamtfläche der Widerstandselemente in einer der zweiten Facette zugewandten Hälfte des Resonators ist, wobei die aktive Schicht entlang der Längsachse eine einheitliche elektrische Kontaktierung aufweist und über die Widerstandselemente die Stromaufteilung innerhalb der Laserdiode zur Vermeidung des longitudinalen Lochbrennens eingestellt ist.

Dies bietet den Vorteil, dass bei einfacher elektrischer Kontaktierung der Kontaktschicht zur Versorgung der gesamten Laserdiode mit elektrischer Energie, die Stromaufteilung innerhalb der Laserdiode gezielt einstellbar ist.

In bevorzugter Ausgestaltung verfügt die Laserdiode über zwei Kontaktschichten zum Ein-, beziehungsweise Auskoppeln von Ladungsträgern in die/aus der aktive(n) Schicht.

Die Widerstandselemente weisen vorzugsweise einen spezifischen elektrischen Widerstand auf, der signifikant größer ist als der spezifische elektrische Widerstand (im Folgenden bezeichnet als $\sigma_c$, beispielsweise $\sigma_c = 1.0 \times 10^{-3}\,\Omega\cdot m$) der verwendeten epitaktischen Schichtstruktur. Bevorzugt beträgt der spezifische elektrische Widerstand der Wider-standselemente mehr als 2 $\sigma_c$, (beispielsweise $2.0 \times 10^{-3}\,\Omega\cdot m$), weiterhin bevorzugt mehr als 10 $\sigma_c$ (beispielsweise $1.0 \times 10^{-2}\,\Omega\cdot m$, weiterhin bevorzugt mehr als $10^2\,\sigma_c$, (beispielsweise $1.0 \times 10^{-1}\,\Omega\cdot m$), weiterhin bevorzugt mehr als $10^3\,\sigma_c$, (beispielsweise $1.0\,\Omega\cdot m$), weiterhin bevorzugt mehr als $10^4\,\sigma_c$, (beispielsweise $1.0 \times 10^1\,\Omega\cdot m$), weiterhin bevorzugt mehr als $10^5\,\sigma_c$, (beispielsweise $1.0 \times 10^2\,\Omega\cdot m$), weiterhin bevorzugt mehr als $10^6\,\sigma_c$, (beispielsweise $1.0 \times 10^{-3}\,\Omega\cdot m$), weiterhin bevorzugt mehr als $10^7\,\sigma_c$, (beispielsweise $1.0 \times 10^4\,\Omega\cdot m$), weiterhin bevorzugt mehr als $10^8\,\sigma_c$, (beispielsweise $1.0 \times 10^5\,\Omega\cdot m$), und besonders bevorzugt mehr als $10^9\,\sigma_c$ (beispielsweise $1.0 \times 10^6\,\Omega\cdot m$).

Die Facetten weisen, als den Resonator begrenzende Elemente, vorzugsweise planare Oberflächen auf. Die Hälften des Resonators werden durch eine Trennebene definiert, die parallel zu den vorzugsweise planaren Facetten orientiert ist, oder mit anderen Worten, von der Längsachse der aktiven Schicht normal geschnitten wird und die sich auf halber Strecke von der Ebene der ersten Facette zur Ebene der zweiten Facette des Resonators entlang der Längsachse der aktiven Schicht befindet.

Weitere vorteilhafte Ausgestaltungen der vorliegenden Erfindung ergeben sich aus den in den Unteransprüchen genannten Merkmalen.

In bevorzugter Ausgestaltung, die ebenfalls von den Ansprüchen nicht umfasst ist, beträgt die Gesamtfläche der Widerstandselemente in der der zweiten Facette zugewandten Hälfte des Resonators 90 %, beziehungsweise das 0,9-Fache, der Gesamtfläche der Widerstandselemente in der der ersten Facette zugewandten Hälfte des Resonators. In weiterhin bevorzugter Ausgestaltung beträgt die Gesamtfläche der Widerstandselemente in der der zweiten Facette zugewandten Hälfte des Resonators 80 % (beziehungsweise das 0,8-Fache), weiterhin bevorzugt 70 %, besonders bevorzugt 66 %, weiterhin bevorzugt 60 %, weiterhin bevorzugt 50 %, weiterhin bevorzugt 40 %, weiterhin bevorzugt 30 %, weiterhin bevorzugt 20 % und weiterhin bevorzugt 10 % der Gesamtfläche der Widerstandselemente in der der ersten Facette zugewandten Hälfte des Resonators. Schließlich stellt eine Variante eine bevorzugte Ausgestaltung dar, bei der sich die Widerstandselemente nur noch in der der ersten Facette zugewandten Hälfte des Resonators befinden und somit die Gesamtfläche der Widerstandselemente in der der zweiten Facette zugewandten Hälfte des Resonators 0% von der Gesamtfläche der Widerstandselemente in der der ersten Facette zugewandten Hälfte des Resonators beträgt. Diese Ausgestaltungen bieten den Vorteil, dass einstellbar zusätzlicher Strom in den Bereich der zweiten Facette, die als Auskoppelfacette ausgebildet ist, geliefert werden kann und dadurch einem Lochbrennungseffekt entgegengewirkt wird.

In weiterer bevorzugter Ausgestaltung, die ebenfalls von den Ansprüchen nicht umfasst ist, erstrecken sich die Widerstandselemente entlang einer Querachse der aktiven Schicht nur über einen Teilbereich der aktiven Schicht. Die aktive Schicht erstreckt sich entlang derselben Achse also über eine längere Strecke, als die Widerstandselemente.

Bevorzugt erstrecken sich die Widerstandselemente achsensymmetrisch oder punktsymmetrisch zu dieser Querachse. Somit ergeben sich an den Flanken der aktiven Schicht Bereiche ohne Widerstandselemente. Dies bietet den Vorteil, dass zusätzlicher Strom an die Flanken der Laserdiode geliefert werden kann und so einer Bildung einer strombedingten thermischen Linse entgegengewirkt wird.

Vorzugsweise beträgt ein Verhältnis der Erstreckung der Widerstandselemente zur gesamten Breite der aktiven Schicht quer zur Längsachse der aktiven Schicht zwischen 1 und 0,1, noch bevorzugter zwischen 0,9 und 0,5 und besonders bevorzugt zwischen 0,8 und 0,6.

In einer weiteren vorteilhaften Ausgestaltung der vorliegenden Erfindung ist vorgesehen, dass die Widerstandselemente mindestens zwei planparallele Flächen aufweisen, deren Normalvektoren parallel zur Längsachse der aktiven Schicht orientiert sind. Dies bietet den Vorteil, dass Filamentierung reduziert wird. Besonders bevorzugt sind die Widerstandselemente streifenförmig mit einer uniformen Schichtdicke (über ihre Längserstreckung).

In besonders bevorzugter Ausgestaltung wird Filamentierung vorteilhafterweise vermieden, indem die Widerstandselemente je mindestens zwei planparallele Flächen aufweisen, die sich über die gesamte Länge des jeweiligen Widerstandselements erstrecken und deren Normalvektoren parallel zur Längsachse der aktiven Schicht orientiert sind. Mit anderen Worten: Die Widerstandselemente weisen in dieser bevorzugten Ausgestaltung eine konstante Breite an jeder Stelle auf und zudem sind alle Widerstandselemente parallel zueinander orientiert. Dies bietet auch den Vorteil, dass optische Verluste und Ladungsträgerverluste minimiert werden.

In weiterer bevorzugter Ausgestaltung sind die Widerstandselemente äquidistant zu einander angeordnet, das heißt die Widerstandselemente sind, in den Bereichen, die mit Widerstandselementen versehen sind, periodisch entlang der Längsachse der aktiven Schicht angeordnet. Dies trägt vorteilhaft dazu bei, dass die elektrischen und thermischen Eigenschaften entlang der Längsachse der aktiven Schicht über je ein Widerstandselement und je einen Bereich zwischen zwei Widerstandselementen hinweg im Mittel konstant bleiben und Leistung sowie Strahlqualität verbessert werden.

Die Widerstandselemente weisen vorzugsweise einen spezifischen elektrischen Widerstand auf, der signifikant größer ist als der spezifische elektrische Widerstand (im Folgenden bezeichnet als $\sigma_c$ beispielsweise $\sigma_c = 1.0\text{x}10^{-3}\,\Omega\cdot\text{m}$) der verwendeten epitaktischen Schichtstruktur. Bevorzugt beträgt der spezifische elektrische Widerstand der Widerstandselemente mehr als $2\,\sigma_c$ (beispielsweise $2.0\text{x}10^{-3}\,\Omega\cdot\text{m}$), weiterhin bevorzugt mehr als $10\,\sigma_c$ (beispielsweise $1.0\text{x}10^{-2}\,\Omega\cdot\text{m}$, weiterhin bevorzugt mehr als $10^2\,\sigma_c$ (beispielsweise $1.0\text{x}10^{-1}\,\Omega\cdot\text{m}$), weiterhin bevorzugt mehr als $10^3\,\sigma_c$ (beispielsweise $1.0\,\Omega\cdot\text{m}$), weiterhin bevorzugt mehr als $10^4\,\sigma_c$, (beispielsweise $1.0\text{x}10^1\,\Omega\cdot\text{m}$), weiterhin bevorzugt mehr als $10^5\,\sigma_c$ (beispielsweise $1.0\text{x}10^2\,\Omega\cdot\text{m}$), weiterhin bevorzugt mehr als $10^6\,\sigma_c$ (beispielsweise $1.0\text{x}10^{-3}\,\Omega\cdot\text{m}$, weiterhin bevorzugt mehr als $10^7\,\sigma_c$ (beispielsweise $1.0\text{x}10^4\,\Omega\cdot\text{m}$), weiterhin bevorzugt mehr als $10^8\,\sigma_c$ (beispielsweise $1.0\text{x}10^5\,\Omega\cdot\text{m}$), und besonders bevorzugt mehr als $10^9\,\sigma_c$ (beispielsweise $1.0\text{x}10^6\,\Omega\cdot\text{m}$).

In weiterer vorteilhafter Ausgestaltung ist vorgesehen, dass die Laserdiode eine Einzelbreitstreifenlaserdiode ist. Dies bietet den Vorteil, dass der Konstruktion eine bekannte, flexible und damit kostengünstig verwendbare Bauart von Laserdioden zugrunde liegt, bei gleichzeitiger Erhöhung, beziehungsweise Verbesserung von Leistung und Strahlqualität.

In einer weiteren vorteilhaften Ausgestaltung ist vorgesehen, dass die Widerstandselemente periodisch zugeordnet werden, mit einer Periode $\Lambda$, die mit Bragg-Bedingungen übereinstimmt. Dies bietet den Vorteil, dass eine Wellenlängenstabilisierung erfolgt. Die notwendige Periode um Diodenlaser bei einer Wellenlänge um $\lambda_0$ zu stabilisieren, kann mit einer Gleichung berechnet werden:

$$\lambda_0 = \frac{2 n_{eff} \Lambda}{N}$$

.

N bezeichnet dabei eine Gitterordnung und $n_{eff}$ bezeichnet den effektiven Brechungsindex einer betrachteten optischen Mode.

Weiterhin ist ein Laser Gegenstand der vorliegenden Erfindung, der zumindest eine vorangehend beschriebene erfindungsgemäße Laserdiode des zweiten Aspekts der Erfindung enthält. Durch Integration mehrere Laserdioden lässt sich die Gesamtleistung des Systems vorteilhaft, zum Beispiel für die Materialbearbeitung, erhöhen. In bevorzugter Ausgestaltung können mehrere erfindungsgemäße Laserdioden miteinander kombiniert werden, um die Leistung des Gesamtsystems vorteilhaft zu erhöhen. Besonders bevorzugt ist eine Parallelschaltung mehrerer Laserdioden zu sogenannten Arrays, oder mit anderen Worten zu Laserbarren. Dies bietet den Vorteil, dass die Kontaktschichten der einzelnen Laserdioden auf einer gemeinsamen Platine angeordnet, beziehungsweise gemeinsam angesteuert werden können. Weiterhin besonders bevorzugt ist eine Serienschaltung mehrerer Laserdioden zu sogenannten Stacks, oder mit anderen Worten zu einem Riegelverbund. Dies bietet zum einen den Vorteil, dass der Bauraum hinsichtlich des horizontalen Flächenbedarfs reduziert wird und zum anderen kann eine gemeinsame Ansteuerung der Laserdioden durch Kontaktierung jeweils einer Kontaktschicht der untersten und der obersten Laserdiode des Riegelverbands erfolgen.

## Kurzbeschreibung der Figuren

Die Erfindung wird nachfolgend anhand zweier Ausführungsbeispiele und dazugehöriger Zeichnungen näher erläutert. Die Figuren zeigen:

Figur 1    eine konventionelle Trapezlaserdiode in schematischer perspektivischer Darstellung;
Figur 2    einen konventionellen Breitstreifenlaser in schematischer perspektivischer Darstellung;
Figur 3    eine nicht von den Ansprüchen umfasste Laserdiode in schematischer perspektivischer Darstellung gemäß einer bevorzugten Ausführungsvariante;
Figur 4    ein bevorzugtes Ausführungsbespiel der erfindungsgemäßen Laserdiode in schematischer perspektivischer Darstellung;
Figur 5    exemplarische grafische Darstellung einer Abhängigkeit der maximalen Laserleistung P von der Breite W3 der Widerstandselemente für eine erfindungsgemäße Laserdiode;
Figur 6    exemplarische grafische Darstellung der Abhängigkeit der maximalen Laserleistung P von dem Gesamtstrom I für eine erfindungsgemäße Laserdiode mit einer Überlappung U von 50% und für eine Laserdiode mit einer Überlappung U von 0 % (dies entspricht dem Stand der Technik);
Figur 7    schematische Darstellung weiterer bevorzugter Ausgestaltungsformen der Widerstandselemente;
Figur 8    exemplarischer Verlauf einer optischen Verstärkung G über einen longitudinalen Querschnitt einer konventionellen Breitstreifenlaserdiode; und
Figur 9    exemplarischer Verlauf einer Temperatur T über einen lateralen Querschnitt einer konventionellen Breitstreifenlaserdiode.

## Detaillierte Beschreibung der Figuren

Figur 3 zeigt eine nicht von den Ansprüchen umfasste Laserdiode 10 gemäß einer bevorzugten Ausführungsvariante. Die Bezugszeichen sind, sofern sie sich auf identische Merkmale beziehen, identisch mit denen des in der Figur 1 beschriebenen Stands der Technik. Die Laserdiode 10 weist eine aktive Schicht 12 auf, die innerhalb eines Resonators 14 angeordnet und mit einem Auskoppelelement 16 wirkverbunden ist. Weiterhin weist die Laserdiode 10 eine erste Kontaktschicht 18 zum Einkoppeln von Ladungsträgern in die aktive Schicht 12 und eine zweite Kontaktschicht 32 zum Auskoppeln von Ladungsträgern aus der aktiven Schicht 12 auf. Weiterhin weist die Laserdiode 10 ein Substrat 58, eine n-Mantelschicht 62, eine n-Wellenleiterschicht 64, eine p-Wellenleiterschicht 68 und eine p-Mantelschicht 70 auf. Die jeweiligen Schichtdicken und Schichtmaterialien gehen aus Tabelle 1 hervor.

**Tabelle 1: Exemplarische Schichtdicken und Schichtmaterialien**

| Schicht | Dicke der Schicht in $\mu$m | Material der Schicht |
|---|---|---|
| zweite Kontaktschicht 32 | Keine Angabe, da Substrat | GaAs (Substrat) |
| Substrat 58 | ~ 120 | GaAs |
| n-Mantelschicht 62 | ~ 1 | $Al_{0.85}Ga_{0.15}As$ |
| aktive Schicht 12 | Summe: 0.052<br>3 x Quantentröge (0.009)<br>2x Spacer (0,005)<br>2x Barrieren (0.0075) | $In_{0.15}Ga_{0.85}As$<br>$GaAs_xP_{1-x}$ (x: 0...0.55)<br>$GaAs_xP_{1-x}$ (x: 0...0.55) |
| n-Wellenleiterschicht 64 | 3.1 | $Al_{0.20}Ga_{0.80}As$ |
| p-Wellenleiterschicht 68 | 1.7 | $Al_{0.20}Ga_{0.80}As$ |
| p-Mantelschicht 70 | ~ 1 | $Al_{0.85}Ga_{0.15}As$ |
| erste Kontaktschicht 18 | - 0.1 | GaAs |

Der Resonator 14 umfasst eine erste Sektion 20 und eine zweite Sektion 22. Die erste Sektion 20 umfasst einen Rippenwellenleiterbereich 28 und die zweite Sektion 22 umfasst einen Trapezbereich 30. Die maximale Breite W1 der aktiven Schicht 12 in der ersten Sektion 20 ist mit 4 $\mu$m (Mikron) kleiner, als die maximale Breite W2 der aktiven Schicht 12 in der zweiten Sektion 22, die 426 $\mu$m beträgt. Die Breite der aktiven Schicht 12 in der ersten Sektion 20 ist konstant und weitet sich über die zweite Sektion 22 gleichmäßig bis auf die maximale Breite W2 auf. Die Länge der ersten Sektion 20 beträgt 2 mm und die Länge der zweiten Sektion 22 beträgt 4mm. Die Projektion der Kontaktschicht 18 entlang einer ersten sich senkrecht zur aktiven Schicht 12 erstreckenden Achse Z1 überlappt sowohl mit der ersten Sektion 20 als auch mit der zweiten Sektion 22. Die zweite Sektion 22 weist zudem eine Vielzahl separater Widerstandselemente 24 auf, eingebracht durch Implantation, die einen spezifischen Widerstand von $1 \times 10^{-1}$ $\Omega \cdot m$ aufweisen und deren spezifischer elektrischer Widerstand um den Faktor ~100 größer ist, als der spezifische elektrische Widerstand der Bereiche 26 zwischen benachbarten Widerstandselementen 24. Wird eine exemplarische Diodenlaser-Schichtstruktur basierend auf $Al_x$-$Ga_{1-x}As$ verwendet, liegt der gesamte elektrische Widerstand bei einer exemplarische Breitstreifenlaserdiode 84 mit 3 mm Resonatorlänge, 90 $\mu m$ Streifenbreite und einer epitaktischen Schichtdicke von 5 $\mu m$ bei 20 m$\Omega$. Der spezifische elektrische Widerstand $\sigma_c$ beträgt in etwa $1.0 \times 10^{-3}$ $\Omega \cdot m$ (und damit beispielsweise etwas größer als der spezifische Widerstand einer hochdotierten $Al_{0.85}Ga_{0.15}As$-Schicht von in etwa $4.2 \times 10^{-4} \Omega \cdot m$).

Die Widerstandselemente 24 sind streifenförmig ausgebildet, mit anderen Worten sie weisen jeweils zwei planparallele Flächen auf, die sich über die gesamte Länge des jeweiligen Widerstandselements 24 erstrecken und deren Normalvektoren parallel zu einer Längsachse X1 des Resonators 14 orientiert sind. Das bedeutet, die Widerstandselemente 24 sind parallel zueinander und zum Resonator 14 orientiert. Dabei beträgt die Breite W3 der Widerstandselemente 24 entlang der Längsachse X1 der aktiven Schicht 12 an jeder Stelle des jeweiligen Widerstandselements 24 5 $\mu m$. Die Breite der Widerstandselemente 24 über ihre Länge, beziehungsweise entlang einer Querachse Y1 ist also konstant. Die Widerstandselemente 24 sind periodisch angeordnet, beziehungsweise äquidistant. Die Periodenlänge beträgt 10 $\mu m$. Die Projektion der Widerstandselemente 24 auf die aktive Schicht 12 entlang der ersten Achse Z1 überlappt mit 50 % mit der aktiven Schicht. Ferner ist die Laserdiode 10 ausgelegt, um mit einer Gleichspannung im Bereich von 1.2, bis 1.6 Volt betrieben zu werden, bevorzugt im Bereich von 1.4 Volt bis 1.6 Volt.

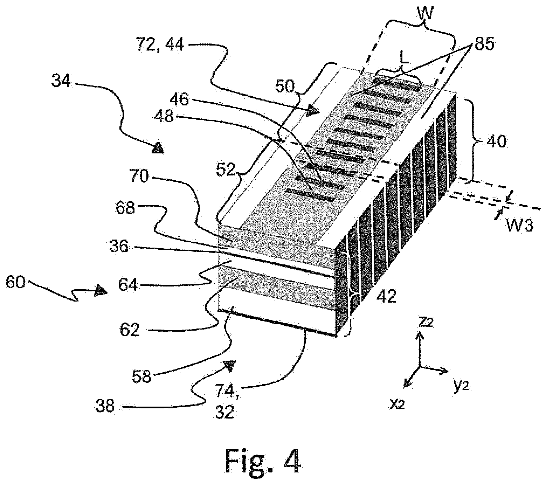

Figur 4 zeigt ein bevorzugtes Ausführungsbeispiel einer erfindungsgemäßen Laserdiode 34. Es handelt sich dabei um eine Einzelbreitstreifenlaserdiode. Die Bezugszeichen sind, sofern sie sich auf identische Merkmale beziehen, identisch mit denen des in der Figur 2 beschriebenen Stands der Technik, beziehungsweise mit denen der in der Figur 3 beschriebenen erfindungsgemäßen Laserdiode 10. Auf einem Substrat 58 sind verschiedene Schichten 60 aufgebracht. Diese bestehen aus einer n-Mantelschicht 62, einer n-Wellenleiterschicht 64 sowie einer p-Wellenleiterschicht 68 und einer p-Mantelschicht 70. In diesem Ausführungsbeispiel umfasst die Laserdiode 34 weiterhin zumindest eine aktive Schicht 36, die innerhalb eines Resonators 38 angeordnet und mit einer ersten Facette 40 und einer zweite Facette 42 wirkverbunden ist. Die zweite Facette 42 ist als Auskoppelelement ausgebildet. Die Laserdiode 34 umfasst weiterhin eine Kontaktschicht 44, die als p-Kontaktbereich 72 fungiert und ausgebildet ist, Strom an die aktive Schicht 36 zu liefern, sowie eine Kontaktschicht 32, die als n-Kontaktbereich 74 fungiert, der ausgebildet ist, Strom aus der aktiven Schicht 36 abzuleiten. Die jeweiligen Schichtdicken und Schichtmaterialien gehen aus Tabelle 2 hervor.

**Tabelle 2: Schichtdicken und Schichtmaterialien**

| Schicht | Dicke der Schicht in $\mu m$ | Material der Schicht |
|---|---|---|
| zweite Kontaktschicht 32 | Keine Angabe, da Substrat | GaAs (Substrat) |
| Substrat 58 | ~ 120 | GaAs |
| n-Mantelschicht 62 | ~ 1 | $Al_{0.85}Ga_{0.15}As$ |
| aktive Schicht 12 | Summe: 0.052<br>3 x Quantentröge (0.009)<br>2x Spacer (0,005)<br>2x Barrieren (0.0075) | $In_{0.15}Ga_{0.85}As$<br>$GaAs_xP_{1-x}$ (x: 0...0.55)<br>$GaAs_xP_{1-x}$ (x: 0...0.55) |
| n-Wellenleiterschicht 64 | 3.1 | $Al_{0.20}Ga_{0.80}As$ |
| p-Wellenleiterschicht 68 | 1.7 | $Al_{0.20}Ga_{0.80}As$ |
| p-Mantelschicht 70 | ~ 1 | $Al_{0.85}Ga_{0.15}As$ |
| erste Kontaktschicht 18 | - 0.1 | GaAs |

Zwischen der ersten Facette 40 und der zweiten Facette 42 ist eine Vielzahl separater Widerstandselemente 46 periodisch (Periodenlänge 10$\mu m$), beziehungsweise äquidistant angeordnet, wobei der spezifische elektrische Widerstand der Widerstandselemente 46 um den Faktor 100 größer ist, als der spezifische elektrische Widerstand von Bereichen 48 zwischen benachbarten Widerstandselementen 46. Der spezifische elektrische Widerstand der Wider-standselemente 46 beträgt $-1 \times 10^{-1}$ $\Omega$ m. Die Widerstandselemente 46 weisen zudem jeweils zwei planparallele Flächen auf, die sich über die gesamte Länge L des jeweiligen Widerstandselements 46 erstrecken und deren Normalvektoren parallel zu einer Längsachse X2 der aktiven Schicht 36, beziehungsweise des Resonators 38 orientiert sind. Das bedeutet die Widerstandselemente 46 sind parallel zueinander und zum Resonator 38 orientiert. Eine Ausdehnung W3 der jeweiligen Widerstandselemente 46 entlang der Längsachse X2 der aktiven Schicht 36 beträgt an jeder Stelle 5 μm, deren Breite ist also konstant. Die Länge L der Widerstandselemente 46 beträgt 60 μm.

Dabei beträgt eine Gesamtfläche der Widerstandselemente 46 in einer der zweiten Facette 42 zugewandten Hälfte 52 des Resonators 38 rund 66 % der Gesamtfläche der Widerstandselemente 46 in einer der ersten Facette 40 zugewandten Hälfte 50 des Resonators 38.

Beide Hälften 50, 52 des Resonators 38 erstrecken sich entlang der Längsachse X2. Die Breite W der aktiven Schicht 36 über die Gesamtlänge des Resonators 38 ist konstant und beträgt 90 μm. In den mit den Widerstandselementen 46 versehenen Bereichen, weisen die Widerstandselemente 46 einen uniformen Abstand zueinander auf. Ausgehend von der Längsachse X2 erstrecken sich die Widerstandselemente 46, achssymmetrisch zu der Längsachse X2, entlang einer Querachse Y2. Die Länge L der jeweiligen Widerstandselemente 46 beträgt dabei 65 % der Breite W der aktiven Schicht 36 entlang der Querachse Y2. An den Flanken 85 ergeben sich somit Bereiche ohne Widerstandselemente 46, die jeweils eine Erstreckung entlang der Querachse Y2 von 35 % der Breite W der aktiven Schicht 36 aufweisen. Das Verhältnis der Breite W der aktiven Schicht 36 zur Länge L der Widerstandselemente 46 quer zur Längsachse der aktiven Schicht beträgt 0,7. Ferner ist die Laserdiode 34 ausgebildet, mit einer Gleichspannung im Bereich von 1.2, bis 1.6 Volt betrieben zu werden, bevorzugt im Bereich von 1.4 Volt bis 1.6 Volt.

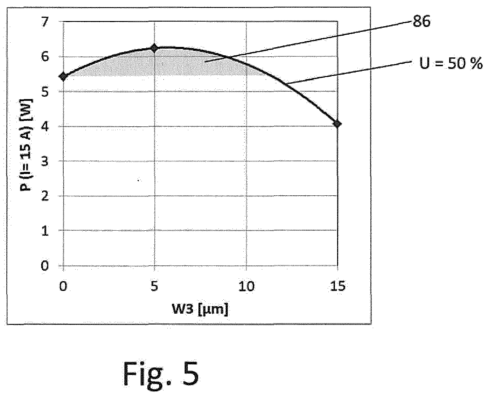

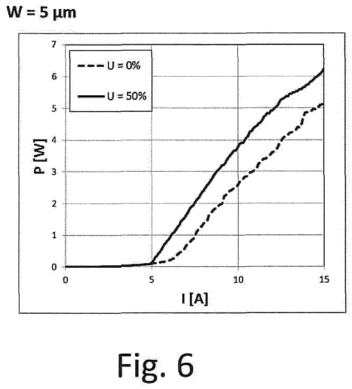

Die Figuren 5 und 6 zeigen exemplarische Auswertungen von Messreihen, die zur Bestimmung optimaler Designparameter für eine erfindungsgemäße Laserdiode durchgeführt worden sind. Es gelten dieselben Bezugszeichen wie in Figur 3. Bei den Versuchen wurden Trapezlaser mit Widerstandselementen 24 in einem Trapezbereich 30 hergestellt. Die Widerstandselemente 24 wurden mit unterschiedlicher Breite von 5 μm bis 15 μm hergestellt. Die Projektion der Widerstandselemente 24 auf die aktive Schicht 12 entlang der ersten Achse Z1 wurde mit 0 %, 30% und 50 % mit der aktiven Schicht 12 überlappend hergestellt.

Eine exemplarische grafische Darstellung einer Abhängigkeit der maximalen Laserleistung P von der Breite W3 der Widerstandselemente 24 für eine erfindungsgemäße Laserdiode 10 ist in Figur 5 für eine konstante Überlappung U (der Projektion der Widerstandselemente 24 auf die aktive Schicht 12 entlang einer sich senkrecht zur aktiven Schicht 12, 36 erstreckenden Achse Z1 mit der gesamten entlang derselben Achse Z1 projizierten Fläche der aktiven Schicht 12) zusammengefasst. Dem Diagramm liegt eine erfindungsgemäße Laserdiode 10 zu Grunde, die mit einem konstanten Strom I betrieben wurde. Dabei wurden der Rippenwellenleiterbereich 28 und der Trapezbereich 30 gemeinsam elektrisch kontaktiert. Es wurden Versuche mit drei erfindungsgemäßen Laserdioden 10 durchgeführt, wobei die Überlappung U konstant bei 50 % lag und die Breite W3 der Widerstandselemente 24 von 5 μm bis 15 μm variiert worden ist. Eine Überlappung von 0 % entspricht einer Trapezlaserdiode nach dem Stand der Technik als Referenz. Aus den Versuchen ergibt sich ein bevorzugtes Gestaltungsfenster 86 für die Breite W3 der Widerstandselemente 24, bei denen die maximale Laserleistung P oberhalb eines Referenzwertes des Standes der Technik liegt.

Ein bevorzugter Bereich für die Breite W3 der Widerstandselemente 24 liegt bei 1 μm bis 9 μm, noch bevorzugter 3 μm bis 7 μm und besonders bevorzugt bei 4 μm bis 6 μm.

Eine exemplarische grafische Darstellung einer Abhängigkeit der maximalen Laserleistung P von der Überlappung U (Projektion der Widerstandselemente 24 auf die aktive Schicht 12 entlang einer sich senkrecht zur aktiven Schicht 12 erstreckenden Achse Z1 mit der gesamten entlang derselben Achse Z1 projizierten Fläche der aktiven Schicht 12) bei konstanter Breite W3 der Widerstandselemente 24 für eine erfindungsgemäße Laserdiode ist in Figur 6 zusammengefasst. Die Versuche erfolgten mit zwei Laserdioden 10. Die Breite W3 der Widerstandselemente 24 lag konstant bei 5 μm und der Gesamtstrom I zur Versorgung von Trapez (30)- und Rippenwellenleiterbereich (28) wurde variiert, um Kennlinien der zwei Laserdioden 10 aufzunehmen. Es sind Kennlinien von je einer Laserdiode 10 mit einer Überlappung U von 0 % (dies entspricht dem Stand der Technik) und 50 % dargestellt. Es ist ersichtlich, dass die maximale Leistung P mit erhöhter Überlappung U ebenfalls ansteigt. Als vorteilhaft hat sich eine Überlappung U von mehr als 10%, bevorzugt mehr als 30 % und insbesondere bevorzugt mehr als 50 % herausgestellt. Vorteilhafte Resultate ergeben sich bis zu einer Überlappung U von bevorzugt nicht mehr als 95 %, besonders bevorzugt nicht mehr als 99 %.

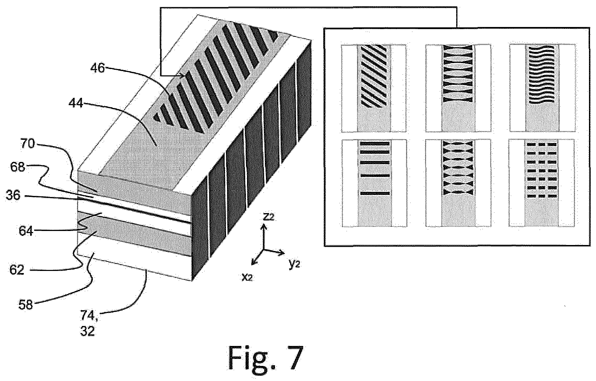

Figur 7 zeigt eine schematische Darstellung weiterer bevorzugter Ausgestaltungsformen der Widerstandselemente 24, 46. Die Darstellung und die Bezugszeichen sind an die Figur 4 angelehnt. Die unterschiedlichen Formen der Widerstandselemente 24, 46 sind aber auf Laserdioden gemäß aller Aspekte der Erfindung übertragbar.

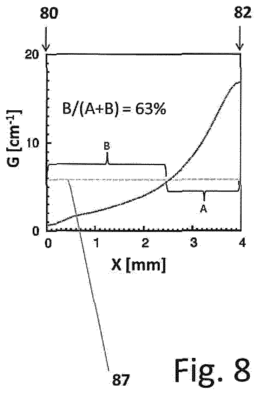

Figur 8 zeigt einen exemplarischen Verlauf einer optischen Verstärkung beziehungsweise eines Gewinns G über einen longitudinalen Querschnitt einer konventionellen Breitstreifenlaserdiode 84 entlang der X-Achse (X-Achse wie in Figur 2 dargestellt). Eine Schnittebene liegt dabei in der X-Z-Ebene und schneidet die Breitstreifenlaserdiode 84 mittig. Aus dem Verlauf des Gewinns über die X-Position (der X-Nullpunkt liegt dabei in der Ebene der Auskoppelfacette 80) lässt sich eine Gestaltungsregel für weitere bevorzugte Ausführungsformen erfindungsgemäßer Laserdioden 34 ableiten. Aus dem Diagramm geht hervor, dass die optische Verstärkung beziehungsweise der Gewinn G in einem Bereich B, dessen Großteil der Frontfacette 80 zugewandt ist, signifikant kleiner ist, als in einem Bereich A, dessen Großteil der Rückfacette 82 zugewandt ist. Der Bereich B mit kleinerem Gewinn G erstreckt sich in diesem exemplarischen Fall über rund 63 % der gesamten Länge des Resonators, also über rund 63 % der Länge von der Frontfacette 80 bis zur Rückfacette 82. Es ist daher ein Ziel, einen erhöhten Stromfluss in dem Bereich B zu realisieren und einen verringerten Stromfluss durch den Bereich A, der sich in diesem exemplarischen Fall über rund 37 % der Länge von der Rückfacette 82 bis zur Frontfacette 80 erstreckt, um den Unterschied im Gewinn G auszugleichen. Die Widerstandselemente 46 sind daher in dem Bereich A zu implantieren. Diese Gestaltungsregel ist auf beliebige Verläufe einer optischen Verstärkung übertragbar beziehungsweise anwendbar, indem zum Beispiel die Widerstandselemente 46 in den Bereichen implantiert werden, in denen der Stromfluss verringert werden soll. Die entsprechende gestalterische Maßnahme bewirkt vorteilhaft eine Erhöhung des Stromflusses durch die Bereiche, in denen keine Widerstandselemente implantiert werden und wirkt dadurch vorteilhaft gegen longitudinales Lochbrennen. Es hat sich herausgestellt, dass bevorzugte Größenordnungen für den Bereich A, in dem die Widerstandselemente 46 eingebracht werden, bei mehr als 10%, weiterhin bevorzugt mehr als 30%, weiterhin bevorzugt mehr als 50% und insbesondere bevorzugt mehr als 60% der Länge von der Rückfacette 82 zur Frontfacette 80 betragen. Dies korrespondiert mit typischen Gewinnverteilungen bekannter Breitstreifenlaserdioden 84.

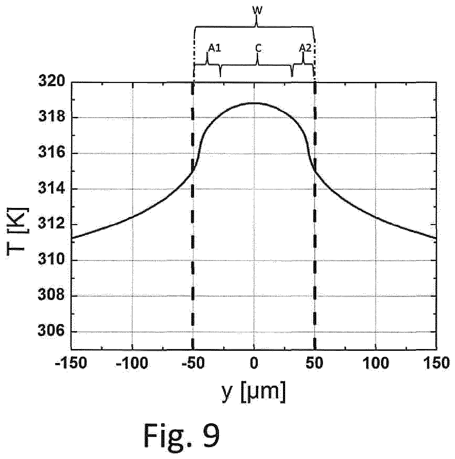

Figur 9 zeigt einen exemplarischen Verlauf einer Temperatur T über einen lateralen Querschnitt entlang der Y-Achse (Y-Achse wie in Figur 2 dargestellt) einer konventionellen Breitstreifenlaserdiode 84. Eine Schnittebene liegt dabei in der Y-Z-Ebene und schneidet die Breitstreifenlaserdiode mittig. Aus dem Verlauf des Gewinns über die Y-Position (der Y-Nullpunkt liegt dabei mittig in der Breitstreifenlaserdiode 84) lässt sich eine Gestaltungsregel für weitere bevorzugte Ausführungsformen erfindungsgemäßer Laserdioden 34 ableiten. Eine Y-Position von 0 mm, die aus der Figur 9 hervorgeht, entspricht in Y-Richtung dem Mittelpunkt der Laserdiode. Aus dem Diagramm geht hervor, dass die Temperatur T dort und in einem mittleren Bereich C größer ist, als in anderen Bereichen. Weiterhin zeigt Figur 9, dass die Temperatur T in Flanken A1, A2 des Kontaktbereichs 72 geringer ist, als in dem mittleren Bereich C. Der Bereich C erstreckt sich in diesem exemplarischen Fall in Y-Richtung über rund 66 % der Breite W des Kontaktbereichs 72. Die Flanken A1, A2 erstrecken sich in diesem exemplarischen Fall in Y-Richtung über je rund 17 % der Breite W des Kontaktbereichs 72. Es ist daher ein Ziel, einen erhöhten Stromfluss in den Flanken A1, A2 zu realisieren und einen verringerten Stromfluss in dem Bereich C. Die Widerstandselemente 46 sind daher in dem Bereich C zu implantieren. Diese Gestaltungsregel ist auf beliebige Temperaturverläufe übertragbar beziehungsweise anwendbar, indem die Widerstandselemente 46 in den Bereichen implantiert werden, in denen der Stromfluss verringert werden soll. Die entsprechende gestalterische Maßnahme bewirkt vorteilhaft eine Erhöhung des Stromflusses durch die Bereiche, in denen keine Widerstandselemente implantiert werden und wirkt dadurch vorteilhaft einer Bildung einer thermischen Linse entgegen.

**Bezugszeichenliste**

| | |
|---|---|
| 10 | Laserdiode |
| 12 | aktive Schicht |
| 14 | Resonator |
| 16 | Auskoppelelement |
| 18 | Kontaktschicht |
| 20 | erste Sektion |
| 22 | zweite Sektion |
| 24 | Widerstandselemente |
| 26 | Bereiche |
| 28 | Rippenwellenleiterbereich |
| 30 | Trapezbereich |
| 32 | Kontaktschicht |
| 34 | Laserdiode |
| 36 | aktive Schicht |
| 38 | Resonator |
| 40 | erste Facette |
| 42 | zweite Facette |
| 44 | Kontaktschicht |
| 46 | Widerstandselemente |
| 48 | Bereiche |
| 50 | Hälfte |
| 52 | Hälfte |
| 54 | Laser |
| 56 | Trapezlaserdiode |

| 58 | Substrat |
|----|----------|
| 60 | Schichten |
| 62 | n-Mantelschicht |
| 64 | n-Wellenleiterschicht |
| 66 | aktive Zone |
| 68 | p-Wellenleiterschicht |
| 70 | p-Mantelschicht |
| 72 | p-Kontaktbereich |
| 74 | n-Kontaktbereich |
| 76 | Rippenwellenleiterbereich |
| 78 | Trapezbereich |
| 80 | Frontfacette |
| 82 | Rückfacette |
| 84 | Breitstreifenlaserdiode |
| 85 | Flanke |
| 86 | Gestaltungsfenster |
| 87 | Ideale uniforme longitudinale Verteilung der lokalen Gewinnkonstante. |
| A | Rückfacette zugewandter Bereich |
| A1 | linke Flanke des Kontaktbereichs |
| A2 | rechte Flanke des Kontaktbereichs |
| B | Frontfacette zugewandter Bereich |
| C | mittlerer Bereich des Kontaktbereichs |
| G | Optische Verstärkung (Gewinn) |
| I | Strom |
| L | Länge |
| P | maximale Laserleistung |
| T | Temperatur |
| U | Überlappung |
| W | Breite |
| W1 | maximale Breite |
| W2 | maximale Breite |
| W3 | Breite |
| X | Längsachse (longitudinale Richtung) |
| X1 | Längsachse (longitudinale Richtung) |
| X2 | Längsachse (longitudinale Richtung) |
| Y | Querachse (laterale Richtung) |
| Y1 | Querachse (laterale Richtung) |
| Y2 | Querachse (laterale Richtung) |
| Z1 | erste Achse (senkrechte Richtung) |
| Z2 | erste Achse (senkrechte Richtung) |
| Z3 | erste Achse (senkrechte Richtung) |
| $\eta$ | Konversionswirkungsgrad |

## Patentansprüche

1. Laserdiode (34), aufweisend:

zumindest eine aktive Schicht (36), die innerhalb eines Resonators (38) angeordnet und mit einer ersten Facette (40) und einer zweite Facette (42) wirkverbunden ist, wobei die zweite Facette (42) als Auskoppelelement ausgebildet ist,
zumindest eine Kontaktschicht (44) zum Einkoppeln von Ladungsträgern in die aktive Schicht (36), und
eine Vielzahl mittels Implantation eingebrachter separater Widerstandselemente (46), die zwischen der ersten Facette (40) und der zweiten Facette (42) angeordnet sind, wobei der spezifische elektrische Widerstand der Widerstandselemente (46) größer ist, als der spezifische elektrische Widerstand von Bereichen (48) zwischen benachbarten Widerstandselementen (46),
wobei eine maximale Ausdehnung der jeweiligen Widerstandselemente (46) entlang einer Längsachse (X2) der aktiven Schicht (36) kleiner als 20 $\mu$m ist und wobei eine Gesamtfläche der Widerstandselemente (46) in einer der ersten Facette (40) zugewandten Hälfte (50) des Resonators (38) größer oder gleich der Gesamtfläche der Widerstandselemente (46) in einer der zweiten Facette (42) zugewandten Hälfte (52) des Resonators (38) ist, wobei die aktive Schicht entlang der Längsachse (X2) eine einheitliche elektrische Kontaktierung aufweist und über die Widerstandselemente (24) die Stromaufteilung innerhalb der Laserdiode (34) zur Vermeidung des longitudinalen Lochbrennens eingestellt ist.

2. Laserdiode (34) nach Anspruch 1, **dadurch gekennzeichnet, dass** die Widerstandselemente (46) mindestens zwei planparallele Flächen aufweisen, deren Normalvektoren parallel zur Längsachse (X2) der aktiven Schicht (36) orientiert sind.

3. Laserdiode (34) nach Anspruch 1 oder 2, **dadurch gekennzeichnet, dass** sich die Widerstandselemente (46) achssymmetrisch oder punktsymmetrisch zu einer Längsachse (X2) der aktive Schicht (36) erstrecken und/oder die maximale Ausdehnung der Widerstandselemente (46) entlang der Längsachse (X2) 6 $\mu$m beträgt.

4. Laserdiode (34) nach einem der vorangegangenen Ansprüche, **dadurch gekennzeichnet, dass** die Laserdiode (34) als Einzelbreitstreifenlaserdiode ausgebildet ist.

5. Laserdiode (34) nach einem der vorangegangenen Ansprüche, **dadurch gekennzeichnet, dass** eine Erstreckung der Widerstandselemente (46) entlang einer Querachse (Y2) zu einer Erstreckung der Kontaktschicht (44) entlang derselben Querachse (Y2) in einem Verhältnis von 0,6 steht.

6. Laser (54), aufweisend:
zumindest eine Laserdiode (34) nach einem der vorangegangenen Ansprüche.

## Claims

1. A laser diode (34), having:

    at least an active layer (36) which is arranged within a resonator (38) and operatively connected to a first facet (40) and a second facet (42), wherein the second facet (42) is formed as a coupling-out element,
    at least a contact layer (44) for coupling charge carriers into the active layer (36), and a plurality of separate resistance elements (46) introduced via implantation and arranged between the first facet (40) and the second facet (42), wherein the specific electrical resistance of the resistance elements (46) is greater than the specific electrical resistance of areas (48) between adjacent resistance elements (46),
    wherein a maximal expansion of the respective resistance elements (46) along a longitudinal axis (X2) of the active layer (36) is smaller than 20$\mu$m and wherein a total surface area of the resistance elements (46) in a half (50) of the resonator (38) facing the first facet (40) is greater than or equal to the total surface area of the resistance elements (46) in a half (52) of the resonator (38) facing the second facet (42), wherein the active layer has uniform electrical bonding along the longitudinal axis (X2) and, via the resistance elements (24), the current distribution within the laser diode (34) is set to avoid longitudinal hole burning.

2. The laser diode (43) according to Claim 1, **characterized in that** the resistance elements (46) have at least two plane-parallel surfaces having normal vectors oriented parallel to the longitudinal axis (X2) of the active layer (36).

3. The laser diode (34) according to Claim 1 or 2, **characterized in that** the resistance elements (46) extend axially symmetrically or point symmetrically to a longitudinal axis (X2) of the active layer (36) and/or the maximal expansion of the resistance elements (46) along the longitudinal axis (X2) is 6$\mu$m.

4. The laser diode (34) according to any one of the preceding claims, **characterized in that** the laser diode (34) is formed to be a single broadband laser diode.

5. The laser diode (34) according to any one of the preceding claims, **characterized in that** an extension of the resistance elements (46) along a transverse axis (Y2) and an extension of the contact layer (44) along the same transverse axis (Y2) have a ratio of 0.6.

6. A laser (54), having:
at least a laser diode (34) according to any one of the preceding claims.

**Revendications**

1. Diode laser (34), présentant :

   au moins une couche active (36), qui est agencée à l'intérieur d'un résonateur (38) et qui est reliée fonctionnellement à une première facette (40) et à une deuxième facette (42), la deuxième facette (42) étant réalisée sous forme d'élément de découplage, au moins une couche de contact (44) pour coupler des porteurs de charge dans la couche active (36), et
   une pluralité d'éléments résistifs séparés (46) introduits par implantation, qui sont agencés entre la première facette (40) et la deuxième facette (42), la résistivité électrique des éléments résistifs (46) étant supérieure à la résistivité électrique de zones (48) entre des éléments résistifs voisins (46),
   dans laquelle une extension maximale des éléments résistifs respectifs (46) le long d'un axe longitudinal (X2) de la couche active (36) est inférieure à 20 $\mu$m et dans laquelle une surface totale des éléments résistifs (46) dans une moitié (50) du résonateur (38) faisant face à la première facette (40) est supérieure ou égale à la surface totale des éléments résistifs (46) dans une moitié (52) du résonateur (38) faisant face à la deuxième facette (42), la couche active présentant un contact électrique uniforme le long de l'axe longitudinal (X2) et la répartition du courant à l'intérieur de la diode laser (34) étant réglée par l'intermédiaire des éléments résistifs (24) afin d'éviter la brûlure par trou longitudinale.

2. Diode laser (34) selon la revendication 1, **caractérisée en ce que** les éléments résistifs (46) présentent au moins deux surfaces planes et parallèles dont les vecteurs normaux sont orientés parallèlement à l'axe longitudinal (X2) de la couche active (36).

3. Diode laser (34) selon la revendication 1 ou 2, **caractérisée en ce que** les éléments résistifs (46) s'étendent de manière axialement symétrique ou ponctuellement symétrique par rapport à un axe longitudinal (X2) de la couche active (36) et/ou l'extension maximale des éléments résistifs (46) le long de l'axe longitudinal (X2) est de 6 $\mu$m.

4. Diode laser (34) selon l'une quelconque des revendications précédentes, **caractérisée en ce que** la diode laser (34) est réalisée sous forme de diode laser à bande large unique.

5. Diode laser (34) selon l'une quelconque des revendications précédentes, **caractérisée en ce qu'**une extension des éléments résistifs (46) le long d'un axe transversal (Y2) est dans un rapport de 0,6 par rapport à une extension de la couche de contact (44) le long du même axe transversal (Y2).

6. Laser (54), présentant :
   au moins une diode laser (34) selon l'une quelconque des revendications précédentes.

Fig. 1

Fig. 2

Fig. 3

Fig. 4

Fig. 5

W = 5 µm

Fig. 6

Fig. 7

Fig. 8

Fig. 9

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6148013 A
- US 6014396 A
- US 5793521 A
- US 5392308 A

### In der Beschreibung aufgeführte Nicht-Patentliteratur

- **C. FIEBIG et al.** *IEEE JSTQE*, 2009, vol. 15 (3), 978-983
- **K. PASCHKE et al.** *IEEE JSTQE*, 2005, vol. 11 (5), 1223-1226
- **B. SUMPF et al.** *Opt. Quant. Electron.*, 2003, vol. 35, 521-532
- **H. WENZEL et al.** *New J. Phys.*, 2010, vol. 12, 085007
- **J. FENG et al.** *Appl. Phys. Lett.*, 1995, vol. 66, 2028-2030
- **P. CRUMP et al.** *Semicond. Sci. Technol.*, 2012, vol. 27, 045001
- **E. O'NEILL et al.** *IEE Proc. Optoelectron.*, 2000, vol. 147, 31-35